# EUROPÄISCHE PATENTSCHRIFT

(11) **EP 1 361 448 B1**
(45) Veröffentlichungstag und Bekanntmachung des Hinweises auf die Patenterteilung: **19.03.2008**
(21) Anmeldenummer: 03001752.9
(22) Anmeldetag: 28.01.2003
(51) Int. Cl.: G01R 31/00, H02J 7/14

(54) **Verfahren und Vorrichtung zur Erkennung einer Fehlfunktion einer Fahrzeugbatteries**
Method and device for detecting the bad functioning of a vehicle's battery
Méthode et dispositif de détection de malfunctionement d'un batterie d'un véhicule

(30) Priorität: 03.05.2002 DE 10219824
(43) Veröffentlichungstag der Anmeldung: 12.11.2003
(73) Patentinhaber: ROBERT BOSCH GMBH, 70442 Stuttgart (DE)
(72) Erfinder: Knapp, Marc, 71729 Erdmannhausen (DE)

(56) Entgegenhaltungen:
- FR-A- 2 766 991
- US-A- 3 629 704
- US-A- 4 379 990
- US-A- 6 114 833
- US-A- 6 150 793

## Beschreibung

Die Erfindung betrifft ein Verfahren und eine Vorrichtung zur Erkennung eines batterielosen Fahrzeugbetriebs nach der Gattung der beiden unabhängigen Patentansprüche.

### Stand der Technik

Die Spannungsversorgung in Kraftfahrzeugbordnetzen wird üblicherweise mit Hilfe eines Generators sichergestellt, der wenigstens eine Batterie auflädt. Die elektrischen Fahrzeugkomponenten sind üblicherweise an die Batterie anschließbar und werden von dieser mit elektrischer Energie versorgt. Da die Batterie mit dem Generator über eine Ladeleitung in Verbindung steht, kann auch bei schlechtem Batteriezustand und gleichzeitig ausreichender Generatorleistung eine Versorgung der elektrischen Verbraucher sichergestellt werden. Problematisch ist es jedoch, wenn die Batterie weitgehend entladen ist oder wenn die Batterie während des Fahrbetriebs zerstört wird oder eine vollständige Unterbrechung zwischen der Batterie und dem Bordnetz auftritt. Ein solcher batterieloser Betrieb stellt die denkbar ungünstigste Betriebsform eines Fahrzeugbordnetzes hinsichtlich der Stabilität des Energiebordnetzes dar. Eine Erkennung eines batterielosen Betriebs ist daher erforderlich, dies gilt insbesondere für Fahrzeuge mit sicherheitsrelevanten elektrischen Verbrauchern. Solche sicherheitsrelevante Verbraucher sind beispielsweise eine elektrische Lenkunterstützung EPS oder ein elektrisches oder elektrohydraulisches Bremssystem. Die Erkennung des batterielosen Betriebs ist erforderlich, um Gegenmaßnahmen einzuleiten oder Warnmeldungen auszugeben.

Bekannte Maßnahmen zur Erkennung eines batterielosen Betriebs eines Fahrzeugbordnetzes ermitteln beispielsweise den Innenwiderstand der Batterie. Wenn der Innenwiderstand der Batterie von erwarteten Werten abweicht, wird auf eine fehlerhafte Batterie oder eine vollkommen defekte Batterie geschlossen und in diesem Fall wird ein batterieloser Bordnetzbetrieb aufrechterhalten. Die Ermittlung des Innenwiderstandes der Batterie erfordert einen verhältnismäßig hohen messtechnischen Aufwand, da beispielsweise der Batteriestrom gemessen werden muss. Darüber hinaus ist die benötigte Rechenleistung für die Quotientenbildung Spannung/Strom erheblich.

Neben der Erfassung des batterielosen Betriebs über eine Messung des Batterieinnenwiderstandes sind auch noch Verfahren zur Erkennung einer defekten Kraftfahrzeugbatterie bekannt, bei denen bei laufendem Motor die Batterie vom Generator auf einen gegenüber dem üblichen Spannungssollwert höheren Wert aufgeladen wird und anschließend von einer elektrischen Last wieder entladen wird. Durch Auswertung der Spannungsdifferenz, die sich beim Auf- bzw. beim Entladen innerhalb eines Zeitintervalls ergibt oder durch Ermittlung des Zeitintervalls, das bis zum Erreichen von zwei Spannungsschwellen abläuft, wird der Betriebszustand der Batterie bzw. ihre Speicherfähigkeit ausgewertet.

Mit solchen Verfahren lässt sich erkennen, wenn eine Batterie defekt ist und nicht mehr zur Versorgung der elektrischen Verbraucher herangezogen werden kann. Solche Verfahren zur Erkennung einer defekten Kraftfahrzeugbatterie sind beispielsweise aus der DE-P 19 964 057.2 bekannt. Diese Verfahren laufen beispielsweise in einem Steuergerät ab, das zusätzlich bei erkanntem Batteriedefekt eine Anzeige auslöst.

Aus der US-A-4,379,900 sind Systeme zur Fehlererkennung und Diagnose bei Batterieladesystemen in Fahrzeugen bekannt, bei denen die Spannungswelligkeit einer gemessenen Spannung Vs, beispielsweise der Batteriespannung ausgewertet wird. Diese Spannung wird mit einer am Eingang des Diagnostikbausteins anliegenden logischen Spannung verglichen und aus dem Vergleichsergebnis wird auf Fehler geschlossen. Da die Spannungsschwankungen der Spannung Vs von der Generatordrehzahl abhängen, ist zusätzlich vorgesehen, wenigstens eine der Phasenspannungen Φ des Generators zu messen und zur Drehzahlermittlung auszuwerten.

### Aufgabe der Erfindung

Die Aufgabe der Erfindung ist, eine einfache und dennoch zuverlässige Erkennung eines batterielosen Betriebs eines Fahrzeugbordnetzes ohne größeren Hardware- und Applikationsaufwand, der ansonsten für die erhebliche Anzahl der möglichen Bordnetz- und Ausstattungskonfigurationen der unterschiedlichen Fahrzeuge entstehen würde, zu ermöglichen. Gelöst wird diese Aufgabe durch die in den beiden unabhängigen Patentansprüchen angegebenen Maßnahmen bzw. Vorrichtungen.

### Vorteile der Erfindung

Das erfindungsgemäße Verfahren sowie die erfindungsgemäße Vorrichtung mit den Merkmalen der beiden unabhängigen Ansprüche hat den Vorteil, dass eine eindeutige Erkennung eines batterielosen Betriebes eines Fahrzeugbordnetzes möglich ist, zusätzlich ist von Vorteil, dass ein erheblicher Toleranzgewinn gegenüber Fehlern und ungenauen Meßgrößen erhalten wird. Erzielt werden diese Vorteile, indem wenigstens zwei batteriecharakteristische Größen ausgewertet und zueinander in Bezug gesetzt werden und bei vorgebbaren Abweichung von erwarteten Werten eine fehlerhafte Batterie oder ein gänzliches Fehlen der Batterie erkannt wird.

Weitere Vorteile der Erfindung werden durch die in den Unteransprüchen angegebenen Maßnahmen erzielt. Dabei ist in einer besonders vorteilhaften Ausgestaltung eine Auswertung der messtechnisch erfassten Generatorspannung und der Spannung an der Batterie vorgesehen. Durch Ermittlung der Welligkeit der beiden Spannungen, also beispielsweise des sogenannten Rippels oder des Spitze-Spitze-Abstandes und die Bildung des Quotienten der beiden vorgenannten Werte für die Generatorspannung und die Batteriespannung ermöglicht eine weitere Absicherung gegen Fehlerkennung. Die Erkennung, dass batterieloser Betrieb vorliegt ist möglich, da in diesem Fall die Oszillationen größer sind und sich das Größenverhältnis zwischen den Spannungswelligkeiten an zwei räumlich getrennten Punkten ändert.

### Zeichnung

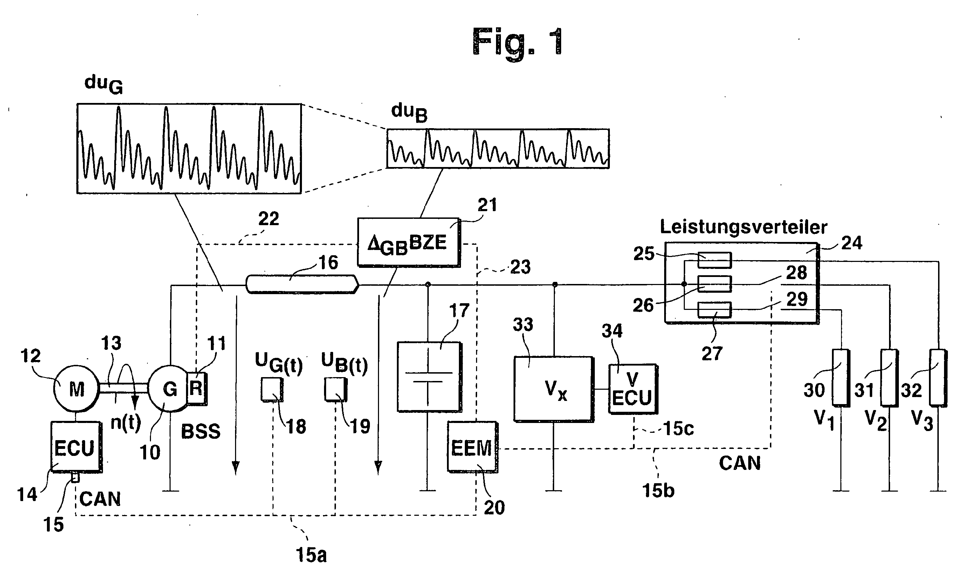

Ein Ausführungsbeispiel der Erfindung ist in der einzigen Figur der Zeichnung dargestellt und wird in der nachfolgenden Beschreibung näher erläutert. Im einzelnen sind in Figur 1 lediglich die für das Verständnis der Erfindung benötigten Bestandteile eines Kraftfahrzeugs bzw. des zugehörigen Bordnetzes sowie die auszuwertenden Meßgrößen dargestellt.

Im einzelnen bezeichnet 10 den Generator, üblicherweise einen Drehstromgenerator, dessen Ausgangsspannung U_{G}(t) mit Hilfe eines Spannungsreglers 11 auf vorgebbare Werte geregelt wird. Der Spannungsregler 11 ist dabei üblicherweise mit dem Generator 10 zusammengebaut. Angetrieben wird der Generator 10 vom Motor 12 des Fahrzeugs, der beispielsweise über einen Keilriemen, eine Welle oder eine sonstige Verbindung 13 mit dem Generator 10 verbunden ist bzw. in Verbindung steht. Die Motordrehzahl ist mit n(t) bezeichnet und entspricht je nach Übersetzungsverhältnis der Generatordrehzahl oder ist zu dieser proportional.

Geregelt wird der Motor mit Hilfe eines elektronischen Steuergerätes 14, das über eine Schnittstelle, beispielsweise eine CAN-Schnittstelle 15 mit weiteren Fahrzeugkomponenten in Verbindung steht. Dem Steuergerät 14 werden über die CAN-Schnittstelle 15 alle benötigten Informationen zugeführt, bzw. das Steuergerät 14 kann über eine bidirektional ausgestattete CAN-Schnittstelle auch Informationen an die übrigen angeschlossenen Komponenten übermitteln.

Der Ausgang des Generators 10, an dem die Spannung U_{G}(t) liegt, ist über eine Leitung 16 mit der Batterie 17 verbunden. An der Batterie 17 liegt die Batteriespannung U_{B}(t). Sowohl die Generatorspannung U_{G}(t), als auch die Batteriespannung U_{B}(t) wird beispielsweise mit Hilfe geeigneter Sensoren 18 und 19 gemessen. Die gemessenen Spannungswerte werden beispielsweise über die CAN-Schnittstelle dem Motorsteuergerät oder dem elektrischen Energiemanagement EEM (20) zugeführt.

Das Fahrzeugbordnetz umfasst weiterhin ein elektrisches Energiemanagement 20 und eine Einrichtung zur Batteriezustandsermittlung 21. Die Einrichtung zur Batteriezustandsermittlung 21 ist über eine Verbindung 22 mit dem Spannungsregler 11 verbunden und über eine Verbindung 23 mit dem elektrischen Energiemanagement. Sowohl die Einrichtung zur Batteriezustandsermittlung, als auch das elektrisches Energiemanagement 20 umfassen gegebenenfalls Mikroprozessoren, die erforderliche Auswertungen vornehmen. Das elektrische Energiemanagement 20 ist über die CAN-Schnittstelle 15 bzw. die zugehörige Verbindung 15a mit dem Motorsteuergerät verbunden und über eine CAN-Verbindung 15b mit dem Leistungsverteiler 24.

Der Leistungsverteiler 24 umfaßt dabei eine Parallelschaltung verschiedener abgesicherter schaltbarer Pfade 25, 26, 27, wobei die Zahl der Pfade beispielhaft ist. Weiterhin umfaßt der Leistungsverteiler 24 zwei Schaltelemente 28, 29, über die die Verbraucher 30 und 31 mit der Batterie 17 verbindbar sind. Die Betätigung der Schaltmittel 28, 29 erfolgt mittels entsprechender Ansteuerung über das elektrische Energiemanagement 20 und versorgt die Verbraucher 30 und 31 bei geschlossenem Schalter. Der Verbraucher 32 ist dauerhaft mit der Batterie verbunden.

Direkt mit der Batterie 17 verbunden ist ein Verbraucher 33, gegebenenfalls ein sicherheitsrelevanter Verbraucher, dem eine Spannungsversorgung 34 für ein elektronisches Steuergerät (ECU) zugeordnet ist. Die Versorgungsschaltung 34 ist zusätzlich über die CAN-Verbindung 15c und 15b mit dem elektrischen Energiemanagement verbunden.

Mit dem in der Figur dargestellten System lässt sich eine Batterieüberwachung realisieren, die sicher und zuverlässig erkennt, wenn die Batterie 17 weitgehend entladen oder defekt ist, oder wenn eine Unterbrechung der Verbindung zwischen der Batterie 17 und dem übrigen Bordnetz auftritt. Dazu wird die Welligkeit der Generatorspannung U_{G}(t) und der Batterie- bzw. Bordnetzspannung U_{B}(t) ausgewertet. Als zusätzliche Größe wird die Ruhespannung der Batterie für den Ladezustand bzw. die State of Charge (SOC)-Bestimmung in Stillstandsphasen ermittelt. Diese Spannungsauswertungen laufen beispielsweise im elektrischen Energiemanagement 20 oder im Motorsteuergerät 14 oder in der Batteriezustandserkennung 21 ab. Da die betreffenden Bauelemente über entsprechende Verbindungen Informationen miteinander austauschen können, kann die Auswertung prinzipiell in jeder der drei Komponenten elektrisches Energiemanagement 20, Motorsteuergerät 14 oder Batteriezustandserkennung 21 ablaufen.

Da die Welligkeit der Bordnetzspannung bzw. der Batteriespannung von vielen Parametern abhängt, ist die eindeutige Erkennung des batterielosen Betriebes aus nur einem Spannungssignal über große Bereiche schwierig. Dies liegt hauptsächlich daran, dass sich der batterielose Betrieb unter bestimmten Voraussetzungen nur gering vom Normalbetrieb in der Spannungswelligkeit abhebt. Dies gilt insbesonders, sofern nur ein Spannungssignal ausgewertet wird, da die Welligkeit im batterielosen Betrieb kleiner sein kann als in anderen Arbeitspunkten des Normalbetriebs. Erfindungsgemäß wird deshalb sowohl die Generatorspannung als auch die Spannung an der Batterie messtechnisch erfasst und es wird zusätzlich die Welligkeit der beiden Spannungen ermittelt, wobei beispielsweise die Spannungsrippel oder der Abstand zwischen Spannungsspitzen, also der Spitze-Spitze-Abstand d_{U} ausgewertet wird. Zusätzlich wird der Faktor a = dU_{G}/dU_{B} gebildet. Mit diesem Quotienten ist für jeden Arbeitspunkt eine Bewertung der momentanen Dämpfungswirkung der Batterie möglich. Unter bestimmten Voraussetzungen kann auch statt der Generatorspannung eine andere Spannung als zweite Spannung ausgewertet werden, die einem zugehörigen Knoten im Bordnetz anliegt.

Durch die Auswertung beider Spannungen U_{G} und U_{B} und das zueinander in Bezug setzen dieser beiden Spannungen, die üblicherweise bei gleichen Voraussetzungen gemessen werden, lassen sich Unzulänglichkeiten ausmitteln. Störeffekte werden dadurch weitgehend ausgeschlossen. Die Auswertung der Spannungen U_{G}(t) und U_{B}(t) kann mit verschiedenen elektronischen Mitteln erfolgen. Beispielsweise können Bandpassfilterungen unter Verwendung geeigneter elektronischer Filter, beispielsweise auch digitaler Filter durchgeführt werden. Aus den Grundschwingungen lassen sich dann über eine momentane Scheitelwertmessung Maximal- und Minimalwerte bestimmen. Die zugehörigen elektronischen Schaltungen sind beispielsweise im Fachbuch Tietze-Schenk "Halbleiter-Schaltungstechnik", 5. überarbeitete Auflage, 1980, S. 665 bis S. 687 beschrieben.

Die so ermittelte Welligkeit der Grundfrequenz der Spannungsschwankungen, die von der Generatordrehzahl abhängt, ermöglicht es zu erkennen, ob die Batterie vorhanden und funktionsfähig ist oder nicht.

Verdeutlicht wird dies durch die in der Figur dargestellten Spannungsverläufe dU_{G}(t) und dU_{B}(t). Diese Spannungsverläufe lassen erkennen, dass grundsätzlich der selbe zeitliche Verlauf der Spannungsoszillationen auftritt, doch die Maximalwerte deutlich unterschiedlich sind. Die ermittelte Welligkeit der Grundfrequenz unterscheidet sich dabei im typischen Normalbetrieb zwischen der Batterieklemme und der Generatorklemme mindestens um einen vorgebbaren Faktor *α_{typ}*, der je nach System im Bereich von 2 bis 5 liegt.

Ein solcher Faktor kann als Schwellwert und damit auch als Entscheidungskriterium dienen. Im batterielosen Betrieb sinkt der Faktor *α* auf Werte, die kleiner sind als Faktor α*_{typ}*. Das Ergebnis des Vergleichs der ausgewerteten Faktor a wird kontinuierlich mit dem Schwellwert Faktor *α_{typ}* verglichen. Wie Erfahrungen gezeigt haben, steigt die Empfindlichkeit der Auswertemethode mit der Drehzahl, also mit der Motor- oder der Generatordrehzahl bzw. der sich einstellenden Spannungsfrequenz, da die Dämpfungseigenschaft der Fahrzeugbatterie und somit der Faktor a mit steigender Frequenz zunimmt.

Bei dem in der Figur dargestellten Prinzip- und Ersatzschaltbild ist im übrigen eine Batteriezustandserkennung für batterielosen Fahrzeugbetrieb vorausgesetzt. Aus dem Vergleich der Spannungswelligkeit am Generator und an der Batterie ist dieser batterielose Fahrzeugbetrieb eindeutig erkennbar. Sind geeignete Mittel zur Anzeige vorhanden, kann der batterielose Fahrzeugbetrieb angezeigt werden. Vorausgesetzt, das elektrische Energiemanagement umfaßt geeignete Mittel, lassen sich auch gleich nach dem Erkennen des batterielosen Betriebs geeignete Gegenmaßnahmen aktivieren, die zu starke Spannungsschwankungen verhindern.

Bei Systemen mit einer einfachen Batteriezustandserkennung, bei denen keine Stromsensorik an der Batterie vorhanden ist, kann das erfindungsgemäße System ebenfalls eingesetzt werden, da lediglich Spannungsmessungen nötig sind. Eine optimale Anpassung des Faktors a an die Gegebenheiten lässt sich beispielsweise auf dem Prüfstand oder nach dem Zusammenbau am Bandende erzielen.

## Patentansprüche

1. Verfahren zur Erkennung eines batterielosen Betriebs eines Fahrzeugbordnetzes, das wenigstens einen von einem Motor angetriebenen Generator, eine Batterie sowie mit der Batterie verbindbare Verbraucher und Mittel zur Spannungsauswertung umfasst und Generatorspannung (U_{G}) und die Batterie- bzw. Bordnetzspannung (U_{B}) gemessen wird, **gekennzeichnet dadurch, dass** aus den ermittelten Spannungswerte sowohl die Welligkeit der Generatorspannung, als auch die Welligkeit der Bordnetzspannung ermittelt wird und die beiden ermittelten Welligkeiten zueinander in Bezug gesetzt werden, wobei die Welligkeit mittels einer Rippel-Ermittlung oder einer Bestimmung des Spitze-Spitze-Abstandes vorgebbarer Spannungsoszillationen ermittelt wird und aus den erhaltenen Ergebnissen der Welligkeitsermittlung auf eine Fehlfunktion der Batterie oder eine Unterbrechung zwischen der Batterie und dem Bordnetz und somit auf einen batterielosen Betrieb erkannt wird.

2. Verfahren zur Erkennung eines batterielosen Fahrzeugbetriebs nach Anspruch 1, **dadurch gekennzeichnet, dass** ein Faktor a gebildet wird aus dem Quotienten dU_{G}/dU_{B}, der mit einem Faktor *α_{typ}* verglichen wird und bei vorgebbarer Abweichungen der beiden Faktoren von einander auf batterielosen Betrieb erkannt wird.

3. Verfahren zur Erkennung eines batterielosen Fahrzeugbetriebes nach Anspruch 2, **dadurch gekennzeichnet, dass** der Faktor *α_{typ}* Werte von 2 bis 5 aufweist.

4. Vorrichtung zur Erkennung eines batterielosen Fahrzeugbetriebs eines Fahrzeugbordnetzes, nach einem der Ansprüche 1 bis 3, das wenigstens einen von einem Motor angetriebenen Generator, eine Batterie sowie mit der Batterie verbindbare Verbraucher und Mittel zur Spannungsauswertung aufweist, **dadurch gekennzeichnet**, die Mittel zur Spannungsauswertung wenigstens einen Bandpass und/oder Mittel zur momentanen Scheitelwertmessung und/oder zur Maximal- und Minimalwertbestimmung von Spannungen umfassen und die Mittel zur Spannungsmessung sowohl die Generatorspannung als auch die Batteriespannung messen.

## Claims

1. Method for identifying battery-free operation of an on-board vehicle electrical system which comprises at least one generator, which is driven by a motor, a battery and also loads, which can be connected to the battery, and means for voltage evaluation, and the generator voltage (U_{G}) and the battery or on-board electrical system voltage (U_{B}) are measured, **characterized by** both the ripple of the generator voltage and the ripple of the on-board electrical system voltage being determined from the determined voltage values, and a relationship being established between the two determined ripples, with the ripple being determined by means of a ripple determination operation or the peak-to-peak distance of predefinable voltage oscillations being determined, and a malfunction of the battery or an interruption between the battery and the on-board electrical system and therefore battery-free operation being identified from the results obtained from the ripple determination operation.

2. Method for identifying battery-free vehicle operation according to Claim 1, **characterized in that** a factor a is formed from the quotient dU_{G}/dU_{B} and is compared with a factor a_{typ}, and battery-free operation is identified when there are predefinable deviations between the two factors.

3. Method for identifying battery-free vehicle operation according to Claim 2, **characterized in that** the factor a_{typ} has values of from 2 to 5.

4. Apparatus for identifying battery-free vehicle operation of an on-board vehicle electrical system according to one of Claims 1 to 3, which on-board vehicle electrical system has at least one generator, which is driven by a motor, a battery and also loads, which can be connected to the battery, and means for voltage evaluation, **characterized in that** the means for voltage evaluation comprise at least one band-pass filter and/or means for instantaneous peak value measurement and/or for maximum and minimum value determination of voltages, and the means for voltage measurement measure both the generator voltage and also the battery voltage.

## Revendications

1. Procédé de détection d'un fonctionnement sans batterie d'un réseau embarqué de véhicule comportant au moins un générateur entraîné par un moteur, une batterie ainsi qu'un utilisateur susceptible d'être relié à la batterie et des moyens d'exploitation de la tension, procédé selon lequel on mesure la tension (UG) du générateur et la tension (UB) de la batterie ou du réseau embarqué,
**caractérisé en ce qu'**
à partir des valeurs de tension obtenues, on détermine l'ondulation de la tension du générateur et aussi l'ondulation de la tension du réseau embarqué et on met en rapport, les deux ondulations ainsi obtenues
l'ondulation se déterminant à l'aide d'une détermination d'ondulation ou d'une détermination de la distance entre les maximum d'oscillations de tension, prédéfinis et à partir des résultats obtenus pour la détermination de l'ondulation, on conclut à un mauvais fonctionnement de la batterie ou à une coupure entre la batterie et le réseau embarqué et ainsi à un fonctionnement sans batterie.

2. Procédé de détection d'un fonctionnement sans batterie d'un véhicule selon la revendication 1,
**caractérisé en ce qu'**
on forme un coefficient (a) à partir du quotient dU_{G}/dU_{B}, que l'on compare à un coefficient a_{typ} et en cas de déviation prédéfinie des deux coefficients l'un par rapport à l'autre, on conclut à un fonctionnement sans batterie.

3. Procédé de détection d'un fonctionnement sans batterie d'un véhicule selon la revendication 2,
**caractérisé en ce que**
le coefficient a_{typ} est compris entre 2 et 5.

4. Dispositif de détection d'un fonctionnement sans batterie d'un réseau embarqué de véhicule selon l'une des revendications 1 à 3, qui comporte au moins un générateur entraîné par un moteur, une batterie, ainsi que des utilisateurs reliés à la batterie et des moyens d'exploitation de la tension,
**caractérisé en ce que**
les moyens d'exploitation de la tension comprennent au moins un filtre passe-bande et/ou des moyens de mesure instantanée des valeurs maximales et/ou de détermination des valeurs maximales et minimales des tension et les moyens de mesure de tension mesurent à la fois la tension du générateur et celle de la batterie.
